(19) Europäisches Patentamt
European Patent Office
Office européen des brevets

(11) **EP 2 346 087 A1**

(12) **EUROPEAN PATENT APPLICATION**
published in accordance with Art. 153(4) EPC

(43) Date of publication:
**20.07.2011 Bulletin 2011/29**

(51) Int Cl.:
***H01L 31/04*** (2006.01)

(21) Application number: **09824681.2**

(22) Date of filing: **02.10.2009**

(86) International application number:
**PCT/JP2009/067247**

(87) International publication number:
**WO 2010/052981 (14.05.2010 Gazette 2010/19)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **05.11.2008 JP 2008284209**

(71) Applicant: **Mitsubishi Heavy Industries, Ltd. Tokyo 108-8215 (JP)**

(72) Inventors:
• **UDA, Kazutaka**
**Nagasaki-shi**
**Nagasaki 851-0392 (JP)**

• **BABA, Tomoyoshi**
**Nagasaki-shi**
**Nagasaki 851-0392 (JP)**
• **ISHIDE, Takashi**
**Nagasaki-shi**
**Nagasaki 851-0392 (JP)**
• **KAWAZOE, Kohei**
**Nagasaki-shi**
**Nagasaki 851-0392 (JP)**
• **NISHIMIYA, Tatsuyuki**
**Nagasaki-shi**
**Nagasaki 851-0392 (JP)**

(74) Representative: **Bongiovanni, Simone**
**STUDIO TORTA**
**Via Viotti 9**
**10121 Torino (IT)**

(54) **PHOTOELECTRIC CONVERSION DEVICE MANUFACTURING METHOD AND PHOTOELECTRIC CONVERSION DEVICE**

(57) Provided is a method for fabricating a photoelectric conversion device in which current is prevented as much as possible from leaking via an intermediate contact layer separating groove. The method includes: a process of forming a top layer (91) mainly containing amorphous silicon; a process of forming on the top layer (91) an intermediate contact layer (93) electrically and optically connected to the top layer (91); a process of removing the intermediate contact layer (93) through irradiation with a pulsed laser and forming an intermediate contact layer separating groove (14) that reaches the top layer (91) to separate the intermediate contact layer (93); and a process of forming, on the intermediate contact layer (93) and in the intermediate contact layer separating groove (14), a bottom layer (92) that mainly contains microcrystalline silicon and that is electrically and optically connected to the intermediate contact layer (93). The intermediate contact layer separating groove (14) is terminated in an i-layer of the top layer (91).

FIG. 1

EP 2 346 087 A1

## Description

Technical Field

The present invention relates to a photoelectric conversion device, for example, used as a thin-film solar cell, and to a method for fabricating the photoelectric conversion device, and, in particular, to a photoelectric conversion device having an intermediate contact layer separating groove formed by a pulsed laser to separate an intermediate contact layer and to a method for fabricating the photoelectric conversion device.

Background Art

In a conventionally known structure, a plurality of photoelectric conversion layers are laminated in order to improve the photoelectric conversion efficiency of a thin-film solar cell. For example, in a known tandem solar cell, an amorphous silicon layer and a microcrystalline silicon layer are laminated. This tandem solar cell is formed by sequentially laminating, on a light transmissive substrate, a transparent electrode, the amorphous silicon layer, the microcrystalline silicon layer, and a back electrode. Further, in a known technology, an electrically and optically connected intermediate contact layer is provided between the amorphous silicon layer and the microcrystalline silicon layer, and part of incident light is reflected, thus further improving the photoelectric conversion efficiency.

In this tandem solar cell, multiple photoelectric conversion cells are serially connected to achieve higher voltage to obtain a desired voltage. When the multiple photoelectric conversion cells are serially connected, a connecting groove that passes through the amorphous silicon layer, the intermediate contact layer, and the microcrystalline silicon layer is formed and is filled with the back electrode, thereby connecting the back electrode and the transparent electrode.
On the other hand, since the intermediate contact layer has electrical conductivity, when it is electrically connected to the connecting groove filled with the back electrode, current produced in the amorphous silicon layer or the microcrystalline silicon layer leaks into the connecting groove via the intermediate contact layer.
Thus, a technology for preventing current leakage from the intermediate contact layer to the connecting groove by separating the intermediate contact layer through laser processing has been proposed (see Patent Literature 1 and Patent Literature 2).

Citation List

Patent Literature

PTL 1

    Japanese Unexamined Patent Application, Publication No. 2002-261308

PTL 2

    Japanese Unexamined Patent Application, Publication No. 2006-313872

Summary of Invention

Technical Problem

However, even if the intermediate contact layer is separated through laser processing, there is still a risk that current leaks from the intermediate contact layer for the following reasons.
When the intermediate contact layer and the amorphous silicon layer are irradiated with a laser so as to separate the intermediate contact layer, the thermal energy of the laser is absorbed in the amorphous silicon layer, and the amorphous silicon layer is melted and ablated together with the intermediate contact layer, thereby forming the intermediate contact layer separating groove. In forming the intermediate contact layer separating groove, the amorphous silicon layer is melted and recrystallized on a wall portion (including a bottom wall) of the intermediate contact layer separating groove. It is considered that, in this recrystallized region, the resistance is reduced because the original amorphous silicon has been altered. The recrystallized region, in which the resistance is reduced, serves as a new current leakage path, thus reducing the cell performance.

As a result of intensive study by the inventors of the present invention, it was found that there are different cases where the resistance is reduced in the recrystallized region depending on the processing depth of the intermediate contact layer separating groove.

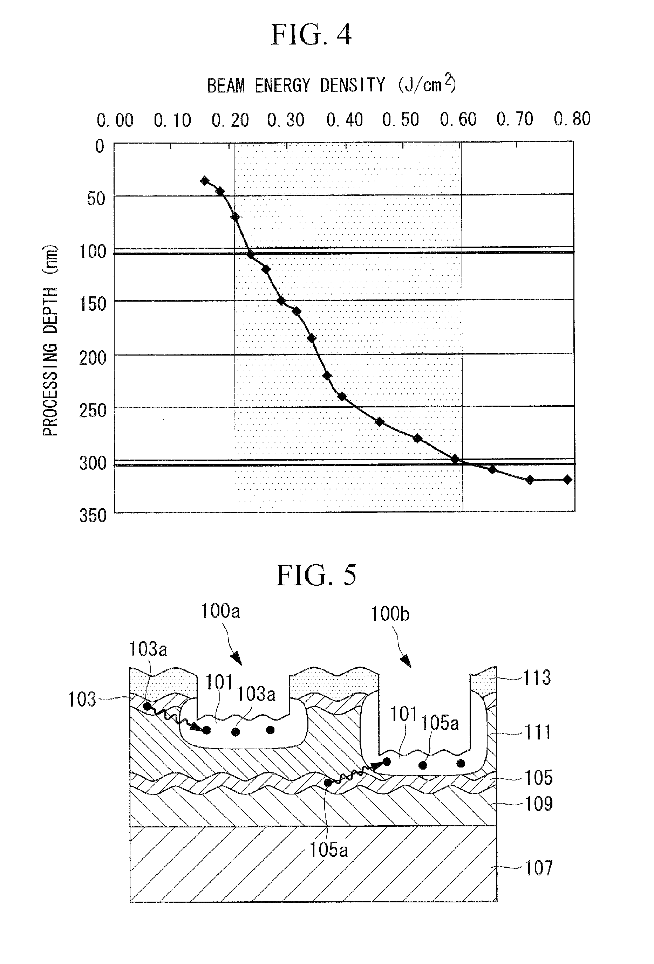

Specifically, first, as shown in the left side of FIG. 5, in a case where an intermediate contact layer separating groove 100a is shallow, a recrystallized region 101 is connected to an amorphous n-layer 103, and donor atoms 103a spread to the recrystallized region 101 from the amorphous n-layer 103, thus reducing the resistance in the recrystallized region 101. Second, as shown in the right side of FIG. 5, in a case where an intermediate contact layer separating groove 100b is deep, the recrystallized region 101 is connected to an amorphous p-layer 105, and acceptor atoms 105a spread to the recrystallized region 101 from the amorphous p-layer 105, thus reducing the resistance in the recrystallized region 101. In FIG. 5, reference numeral 107 denotes a glass substrate, reference numeral 109 denotes a transparent electrode layer, reference numeral 111 denotes an amorphous i-layer, and reference numeral 113 denotes an intermediate contact layer.

The present invention has been made in view of these circumstances, and an object thereof is to provide a photoelectric conversion device in which current is prevented as much as possible from leaking via an intermediate contact layer separating groove, as well as a method for fabricating the photoelectric conversion device.


Solution to Problem

In order to solve the above-described problems, the photoelectric conversion device fabrication method and the photoelectric conversion device of the present invention employ the following solutions.
Specifically, according to one aspect, the present invention provides a photoelectric conversion device fabrication method including: a first photoelectric conversion layer forming process of forming a first photoelectric conversion layer that mainly contains silicon; an intermediate contact layer forming process of forming, on the first photoelectric conversion layer, an intermediate contact layer that is electrically and optically connected to the first photoelectric conversion layer; an intermediate contact layer separating process of removing the intermediate contact layer through irradiation with a laser and forming an intermediate contact layer separating groove that reaches the first photoelectric conversion layer, to separate the intermediate contact layer; and a second photoelectric conversion layer forming process of forming a second photoelectric conversion layer that mainly contains silicon and that is electrically and optically connected to the intermediate contact layer, on the intermediate contact layer and in the intermediate contact layer separating groove, in which: the first photoelectric conversion layer is composed of an i-layer, a p-layer, and an n-layer, the p-layer and the n-layer being formed so as to sandwich the i-layer; and, in the intermediate contact layer separating process, the intermediate contact layer separating groove is formed so as to terminate in the i-layer of the first photoelectric conversion layer.

Thermal energy imparted through irradiation with a laser melts the intermediate contact layer and the first photoelectric conversion layer causing them to be ablated, thus forming a groove in the laser-irradiated part. Thus, an intermediate contact layer separating groove that separates the intermediate contact layer is formed. On a wall portion of the intermediate contact layer separating groove, no small recrystallized region in which melted silicon is recrystallized exists.
In the above-described aspect, the termination position of the intermediate contact layer separating groove is in the i-layer of the first photoelectric conversion layer. By doing so, a connection between the recrystallized region existing around the intermediate contact layer separating groove and the n-layer or the p-layer is avoided, donor atoms are prevented from spreading from the n-layer to the recrystallized region, and acceptor atoms are prevented from spreading from the p-layer to the recrystallized region. Therefore, a situation in which the donor atoms in the n-layer or the acceptor atoms in the p-layer spread to the recrystallized region to cause a reduction in the resistance thereof is avoided; thus the recrystallized region is prevented from serving as a current leakage path.
An amorphous silicon layer is preferably used as the first photoelectric conversion layer, and a microcrystalline silicon layer is used as the second photoelectric conversion layer. GZO (Ga-doped ZnO) is preferably used for the intermediate contact layer.

Furthermore, in the photoelectric conversion device fabrication method according to the aspect of the present invention, the termination position of the intermediate contact layer separating groove is at substantially the center in a film thickness direction of the i-layer.

When the termination position of the intermediate contact layer separating groove is at substantially the center position in the film thickness direction of the i-layer, the termination position of the intermediate contact layer separating groove can be kept away from the p-layer and the n-layer, which are formed so as to sandwich the i-layer. Thus, the recrystallized region, produced when the intermediate contact layer separating groove is formed, can be prevented as much as possible from being connected to the p-layer or the n-layer.
The range of the center position in the i-layer is determined in consideration of the fact that the unevenness of the surfaces of the transparent electrode and the light transmissive substrate, which are layers under the first photoelectric conversion layer, influences the film thickness distribution of the i-layer. For example, when the range of unevenness is ±30% of the thickness of the i-layer, it is preferred that the termination position of the intermediate contact layer separating groove be specified within a range of ±30% of the thickness of the i-layer from the center position in the thickness of the i-layer, so as to fall in a range similar to the range of unevenness.

Furthermore, in the photoelectric conversion device fabrication method according to the aspect of the present invention, the termination position of the intermediate contact layer separating groove is determined by adjusting a power density indicating the output of the pulsed laser per unit area.

It was found that there is a predetermined relationship between the power density ($J/cm^2$) of a pulsed laser and the processing depth. Then, the termination position of the intermediate contact layer separating groove is determined by adjusting the power density of a pulsed laser, and thus the intermediate contact layer separating groove can be processed to have a desired depth with high reproducibility.

According to another aspect, the present invention provides a photoelectric conversion device including: a first photoelectric conversion layer that mainly contains silicon; an intermediate contact layer that is electrically and optically connected to the first photoelectric conversion layer; and a second photoelectric conversion layer that mainly contains silicon and that is electrically and optically connected to the intermediate contact layer, in which: an intermediate contact layer separating groove that passes through the intermediate contact layer so as to separate the intermediate contact layer and that reaches the first photoelectric conversion layer is formed; the first photoelectric conversion layer is composed of an i-layer, a p-layer, and an n-layer, the p-layer and the n-layer being formed so as to sandwich the i-layer; and the intermediate contact layer separating groove is terminated in the i-layer of the first photoelectric conversion layer.

Thermal energy imparted through irradiation with a laser melts the intermediate contact layer and the first photoelectric conversion layer causing them to be ablated, thus forming a groove in the laser-irradiated part. Thus, an intermediate contact layer separating groove for separating the intermediate contact layer is formed. On a wall portion of the intermediate contact layer separating groove, no small recrystallized region in which melted silicon is recrystallized exists.

In the above-described other aspect, the termination position of the intermediate contact layer separating groove is in the i-layer of the first photoelectric conversion layer. By doing so, a connection between the recrystallized region existing around the intermediate contact layer separating groove and the n-layer or the p-layer is avoided, donor atoms are prevented from spreading from the n-layer to the recrystallized region, and acceptor atoms are prevented from spreading from the p-layer to the recrystallized region. Therefore, a situation in which the donor atoms in the n-layer or the acceptor atoms in the p-layer spread to the recrystallized region to cause a reduction in the resistance thereof is avoided; thus the recrystallized region is prevented from serving as a current leakage path.

An amorphous silicon layer is preferably used as the first photoelectric conversion layer, and a microcrystalline silicon layer is used as the second photoelectric conversion layer.

GZO (Ga-doped ZnO) is preferably used for the intermediate contact layer.

Further, in the photoelectric conversion device according to the other aspect of the present invention, the termination position of the intermediate contact layer separating groove is at substantially the center in a film thickness direction of the i-layer.

When the termination position of the intermediate contact layer separating groove is at substantially the center position in the film thickness direction of the i-layer, the termination position of the intermediate contact layer separating groove can be kept away from the p-layer and the n-layer, which are formed so as to sandwich the i-layer. Thus, the recrystallized region, produced when the intermediate contact layer separating groove is formed, can be prevented as much as possible from being connected to the p-layer or the n-layer.

It is preferable that the center position of the i-layer be determined within a range of $\pm 30\%$ of the thickness of the i-layer from the center position in the thickness of the i-layer, in consideration of the unevenness of the surfaces of the transparent electrode and the light transmissive substrate, which are layers under the first photoelectric conversion layer.

Advantageous Effects of Invention

According to the present invention, the termination position of the intermediate contact layer separating groove is in the i-layer of the first photoelectric conversion layer, and a connection between the recrystallized region existing around the intermediate contact layer separating groove and the n-layer or the p-layer is avoided; thus, a reduction in the resistance in the recrystallized region can be prevented. Thus, a situation in which a new current leakage path is formed when the intermediate contact layer separating groove is formed is prevented, realizing an improvement in the efficiency of the photoelectric conversion device.

Brief Description of Drawings

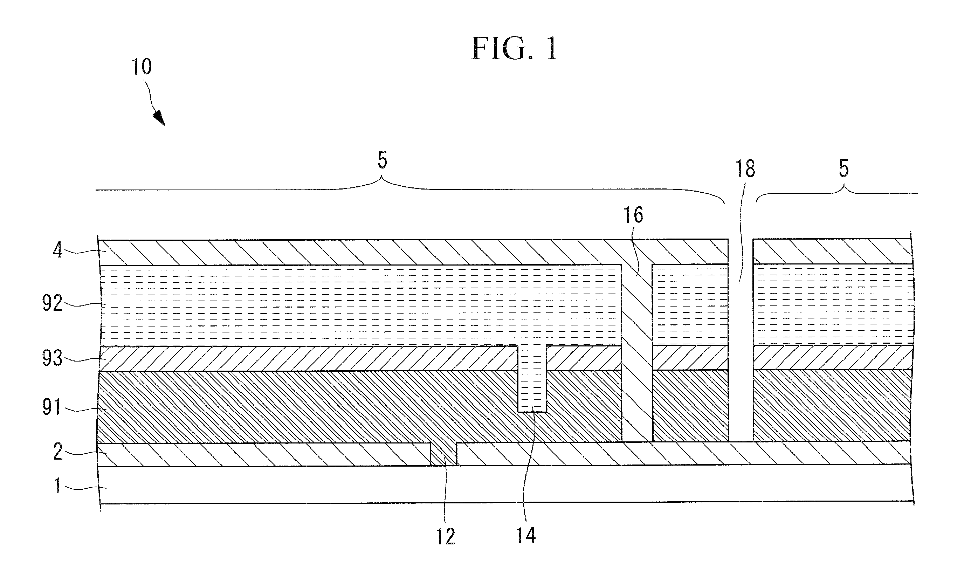

{FIG. 1} FIG. 1 is a longitudinal sectional view showing a tandem solar cell according to one embodiment of the present invention.

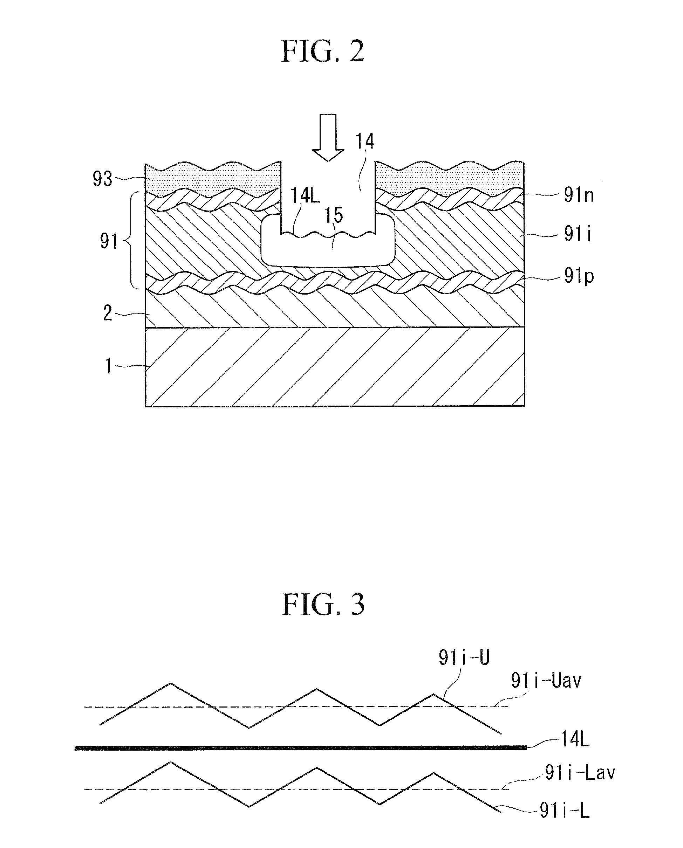

{FIG. 2} FIG. 2 is a longitudinal sectional view showing a state where an intermediate contact layer separating groove is formed in an intermediate contact layer separating process.

{FIG. 3} FIG. 3 is a conceptual diagram schematically showing the concept of determining the termination position of the intermediate contact layer separating groove with respect to a change in thickness of an amorphous i-layer.

{FIG. 4} FIG. 4 is a graph showing the relationship between the energy density of a nanosecond pulsed laser and the processing depth.

{FIG. 5} FIG. 5 is a longitudinal sectional view schematically showing states where recrystallized regions are reduced in resistance because of the depths of the intermediate contact layer separating grooves.

Description of Embodiments

An embodiment of the present invention will be described below with reference to the drawings.

FIG. 1 shows a longitudinal section of a tandem silicon thin-film solar cell (photoelectric conversion device). A solar cell 10 includes a glass substrate (light-transmitting substrate) 1, a transparent electrode layer 2, a top layer (first photoelectric conversion layer) 91, an intermediate contact layer 93, a bottom layer (second photoelectric conversion layer) 92, and a back electrode layer 4. In this embodiment, the top layer 91 is a photoelectric conversion layer mainly having amorphous silicon semiconductor, and the bottom layer 92 is a photoelectric conversion layer mainly having crystalline silicon semiconductor.

Here, "silicon" is a general term including silicon (Si), silicon carbide (SiC), and silicon germanium (SiGe). Further, "crystalline silicon" is intended to mean silicon other than amorphous silicon, in other words, noncrystalline silicon, and also includes microcrystalline silicon and polycrystalline silicon.

The thus-configured solar cell 10 of this embodiment is fabricated as follows.

Soda float glass having a size of 1 m square is used as the glass substrate 1. Specifically, soda float glass having a size of 1.4 m x 1.1 m and a thickness of 3.5 mm to 4.5 mm is used. It is preferable that end faces of the glass substrate 1 be subjected to a corner chamfering process or an R-chamfering process in order to avoid damage caused by thermal stress, impacts, or the like.

A transparent electrode film that is composed mainly of tin oxide film ($SnO_2$), for example, is preferably used as the transparent electrode layer 2. The transparent electrode film has a thickness of approximately 500 nm to 800 nm and is obtained through a film-forming process at approximately 500 °C using a thermal CVD device. During this film-forming process, a suitable uneven texture is formed on a surface of the transparent electrode film. As a part of the transparent electrode layer 2, an alkali barrier film (not shown) may also be formed between the transparent electrode film and the substrate 1. The alkali barrier film is a silicon oxide film ($SiO_2$) having a thickness of 50 nm to 150 nm, for example, and is obtained through the film-forming process at approximately 500 °C using the thermal CVD device.

Then, the glass substrate 1 is placed on an X-Y table and irradiated from a film surface side of the transparent electrode layer 2 (from the upper side in the figure) with the first harmonic (1064 nm) of a YAG laser. The laser power is adjusted so as to be appropriate for the process speed, and the transparent electrode layer 2 on the glass substrate 1 and the laser beam are relatively moved in a direction perpendicular to the serial connection direction of a power generation cell 5 (in the direction perpendicular to the plane of the figure) to form a transparent electrode separating groove 12. As a result, the transparent electrode layer 2 is laser-etched in a rectangular shape having a predetermined width of approximately 6 mm to 15 mm.

Next, using a plasma CVD device, under conditions in which the reduced-pressure atmosphere is set to 30 to 1000 Pa and the substrate temperature is set to approximately 200 °C, a p-layer film, an i-layer film, and an n-layer film that are each formed of an amorphous silicon thin film are sequentially formed, thus forming the top layer 91 (first photoelectric conversion layer forming process). The top layer 91 is formed on the transparent electrode layer 2 with process gas mainly composed of $SiH_4$ gas and $H_2$ gas. From a sunlight incident side (glass substrate 1 side), the p-layer, the i-layer, and the n-layer are laminated in this order.

In this embodiment, the top layer 91 is composed of an amorphous p-layer mainly containing B-doped amorphous SiC and having a thickness of 10 nm to 30 nm, an amorphous i-layer mainly containing amorphous Si and having a thickness of 200 nm to 350 nm, and an amorphous n-layer mainly containing p-doped Si-layer that contains microcrystalline Si in amorphous Si and having a thickness of 30 nm to 50 nm. Further, a buffer layer may also be provided between the p-layer film and the i-layer film in order to improve the interface properties.

Next, a GZO (Ga-doped ZnO) film is formed as the intermediate contact layer 93 on the top layer 91 (intermediate contact layer forming process). The GZO (Ga-doped ZnO) film has a thickness of 20 nm to 100 nm and is formed using a sputtering device. The intermediate contact layer 93 can improve the contact properties between the top layer 91 and the bottom layer 92 and obtain current consistency therebetween. The intermediate contact layer 93 is a semireflecting film and reflects part of light incident from the glass substrate 1, thereby realizing an improvement in photoelectric conversion efficiency in the top layer 91.

Next, the glass substrate 1 is placed on the X-Y table and irradiated from the film surface side of the transparent electrode layer 2 (from the upper side in the figure) with a YVO4 pulsed laser (hereinafter, referred to as "nanosecond pulsed laser") having a wavelength of 532 nm and a pulse width of the order of nanoseconds (1 to 100 ns). With this nanosecond pulsed laser, an intermediate contact layer separating groove 14 is formed between the transparent electrode separating groove 12 and a connecting groove 16 (intermediate contact layer separating process). As shown in FIG. 2, the intermediate contact layer separating groove 14 is terminated in an i-layer 91i of the top layer 91. The intermediate contact layer separating process will be described later in detail.

Next, using the plasma CVD device, under conditions in which the reduced-pressure atmosphere is set to 3,000 Pa or less, the substrate temperature is set to approximately 200 °C, and the plasma generation frequency is set to 40 MHz to 100 MHz, a microcrystalline p-layer film, a microcrystalline i-layer film, and a microcrystalline n-layer film that are each made of a microcrystalline silicon thin film are sequentially formed, thus forming the bottom layer 92 on the intermediate contact layer 93 and in the intermediate contact layer separating groove 14 (second photoelectric conversion layer forming process).
In this embodiment, the bottom layer 92 is composed of the microcrystalline p-layer mainly containing B-doped microcrystalline SiC and having a thickness of 10 nm to 50 nm, the microcrystalline i-layer mainly containing microcrystalline Si and having a thickness of 1.2 $\mu$m to 3.0 $\mu$m, and the microcrystalline n-layer mainly containing p-doped microcrystalline Si and having a thickness of 20 nm to 50 nm.

When the microcrystalline silicon thin film, in particular, the microcrystalline i-layer film, is formed by the plasma CVD method, it is preferable that a distance d between a plasma discharge electrode and the surface of the glass substrate 1 be set to 3 mm to 10 mm. If the distance d is shorter than 3 mm, it is difficult to keep the distance d constant because of the precision of each component device in a film forming chamber for a large substrate, and there is a risk that the discharge becomes unstable because it is too close. If the distance d is longer than 10 mm, it is difficult to obtain a sufficient film formation speed (1 nm/s or more), the plasma uniformity is reduced, and the film quality is reduced because of ion bombardment.

Next, the glass substrate 1 is placed on the X-Y table and irradiated from the film surface side of the bottom layer 92 (from the upper side in the figure) with the second harmonic (532 nm) of a laser-diode-pumped YAG laser, as indicated by an arrow in the figure. The pulse oscillation frequency is set to 10 to 20 kHz to adjust the laser power so as to be appropriate for the process speed, and the connecting groove 16 is formed at a position approximately 50 to 350 $\mu$m away laterally from the transparent electrode separating groove 12. The glass substrate 1 side may be irradiated with the laser; in this case, high vapor pressure produced by the energy absorbed in the top layer 91 can be used for etching the intermediate contact layer 93 and the bottom layer 92, thereby allowing a more stable laser etching process to be performed. The position of a laser etching line is selected by taking the positioning tolerance into account so as not to cross an etching line formed in the previous process.

Next, an Ag film and a Ti film are sequentially formed as the back electrode layer 4 by using the sputtering device in the reduced-pressure atmosphere at approximately 150 to 200 °C. In this embodiment, in the back electrode layer 4, the Ag film having a thickness of approximately 150 to 500 nm and the Ti film having a high anti-corrosion effect and a thickness of 10 to 20 nm, which is used to protect the Ag film, are laminated in this order. Alternately, an Ag film having a thickness of approximately 25 nm to 100 nm and an Al film having a thickness of approximately 15 nm to 500 nm may be laminated. A GZO (Ga-doped ZnO) film having a thickness of 50 to 100 nm may be formed between the bottom layer 92 and the back electrode layer 4 by using the sputtering device, in order to reduce the contact resistance between the n-layer and the back electrode layer 4 and improve the light reflection.

Next, the glass substrate 1 is placed on the X-Y table and irradiated from the glass substrate 1 side (from the lower side in the figure) with the second harmonic (532 nm) of the laser-diode-pumped YAG laser. The laser beam is absorbed in the top layer 91 and the bottom layer 92 to produce high gas vapor pressure, and the high gas vapor pressure is used to explode and remove the back electrode layer 4. The pulse oscillation frequency of the laser is set to 1 to 10 kHz to adjust the laser power such that the process speed becomes appropriate, and laser etching is performed to form a cell separating groove 18 at a position approximately 250 to 400 $\mu$m away laterally from the transparent electrode separating groove 12.

After the above-described processes, a process of attaching a back sheet having a high waterproof effect to the back electrode layer 4 so as to cover it, via an adhesive filling material sheet, such as EVA (ethylene-vinyl acetate copolymer), and other processes are performed, thereby fabricating the solar cell.

The above-described intermediate contact layer separating process will be described below in detail.
The laser used in this process is a nanosecond pulsed laser having a pulse width of 1 ns to 100 ns. Specifically, a YVO4 laser (wavelength: 532 nm) having an oscillating frequency of 12 kHz and a beam spot diameter of 90 $\mu$m is preferably used. The process speed (that is, the speed at which laser light is emitted to the glass substrate 1) is approximately 800 mm/s, for example.
As the laser light, the second harmonic (532 nm) of a YAG laser or a fiber laser may be used.

As shown in FIG. 2, the termination position (a bottom portion) of the intermediate contact layer separating groove 14 is located in the i-layer 91i of the top layer 91. Specifically, a termination position 14L of the intermediate contact layer separating groove 14 is not located in an n-layer 91n or a p-layer 91p of the top layer 91. With this structure, a recrystallized region 15 that is formed on a wall portion (including the bottom portion) of the intermediate contact layer separating groove 14 when amorphous silicon is melted and coagulated can be separated from the n-layer 91n and the p-layer 91p. Therefore, dopant in the n-layer 91n or the p-layer 91p can be prevented from spreading to the recrystallized region 15, and a reduction in the resistance of the recrystallized region, caused by the dopant, can be avoided. The recrystallized region 15 can be confirmed with a transmission electron microscope or the like.

FIG. 3 shows the concept of specifying the termination position 14L of the intermediate contact layer separating groove 14.

In this figure, a thick line located at the center indicates the termination position 14L of the intermediate contact layer separating groove 14. Therefore, in this figure, the vertical direction corresponds to the film thickness direction.

In this figure, a triangle-wave-like uneven line 91i-L located below the termination position 14L indicates the interface between the amorphous i-layer 91i and the amorphous p-layer 91p. The uneven shape of the line is produced by the uneven texture structure formed on the surface of the transparent electrode layer 2. A dashed line 91i-Lav shown at substantially the center of the uneven line 91i-L is an average line indicating the average value in the film thickness direction of the uneven line 91i-L.

In this figure, a triangle-wave-like uneven line 91i-U located above the termination position 14L indicates the interface between the amorphous i-layer 91i and the amorphous n-layer 91n. The uneven shape of the line is produced by the uneven texture structure formed on the surface of the transparent electrode layer 2. A dashed line 91i-Uav shown at substantially the center of the uneven line 91i-U is an average line indicating the average value in the film thickness direction of the uneven line 91i-U.

The termination position 14L of the intermediate contact layer separating groove 14 is determined by taking account of the uneven levels of the uneven lines 91i-L and 91i-U. For example, when there is an unevenness of $\pm 30\%$ with respect to the thickness of the amorphous i-layer 91i (the distance between the dashed lines 91i-Lav and 91i-Uav), the position of the termination position 14L is specified within a range of $\pm 30\%$ of the thickness of the i-layer film from the center position in the thickness of the amorphous i-layer 91i, so as to match this unevenness.

As a result of intensive study by the inventors of the present invention, it was found that the termination position 14L of the intermediate contact layer separating groove 14 can be adjusted by the beam energy density for a silicon material (more specifically, amorphous silicon) used in this embodiment. Specifically, it was found that there is a fixed relationship between the beam energy density of the nanosecond pulsed laser and the processing depth. This relationship is shown in FIG. 4. When the processing depth is indicated by y (nm), and the beam energy density is indicated by x $(J/cm^2)$, the relationship is expressed by the following quadratic expression.

$$y = -1373.4x^2 + 1700x - 226.95 \quad \cdots (1)$$

When the intermediate contact layer 93 has a thickness of 70 nm, and the top layer 91 has a thickness of 250 nm (the p-layer: 15 nm, the i-layer: 200 nm, and the n-layer: 35 nm), the processing depth needs to be "70 + 35 = 105 nm" or more so that the termination position 14L is not located in the amorphous n-layer 91n. On the other hand, the processing depth needs to be "70 + 35 + 200 = 305 nm" or less so that the termination position 14L is not located in the amorphous p-layer 91p.

In this processing depth range, that is, in a processing depth range of 105 to 305 nm, the above expression (1) is approximated with high precision.

Therefore, as shown in FIG. 4, in order to realize the processing depth of 105 to 305 nm, the output of the nanosecond pulsed laser just needs to be adjusted to have an energy density ranging from 0.24 J/cm$^2$ (12 kHz, 0.18 W) to 0.6 J/cm$^2$ (12 kHz, 0.45 W). However, it is preferable that the output of the nanosecond pulsed laser be adjusted to have an energy density ranging from 0.3 to 0.4 J/cm$^2$ for stable output.

According to this embodiment described above, the following advantages are afforded.

The termination position 14L of the intermediate contact layer separating groove 14 is in the amorphous i-layer 91i of the top layer 91. By doing so, a connection between the recrystallized region 15 existing around the intermediate contact layer separating groove 14 and the amorphous n-layer 91n or the amorphous p-layer 91p is avoided; donor atoms are prevented from spreading from the n-layer to the recrystallized region 15; and acceptor atoms are prevented from spreading from the p-layer to the recrystallized region 15. Therefore, a situation in which the donor atoms in the n-layer or the acceptor atoms in the p-layer spread to the recrystallized region 15 to cause a reduction in the resistance thereof is avoided, and thus the recrystallized region 15 is prevented from serving as a current leakage path.

When the termination position 14L of the intermediate contact layer separating groove 14 is at substantially the center in the film thickness direction of the amorphous i-layer 91i, the termination position 14L of the intermediate contact layer separating groove 14 can be kept away from the amorphous p-layer 91p and the amorphous n-layer 91n, which are formed so as to sandwich the amorphous i-layer 91i. Thus, the recrystallized region 15, produced when the intermediate contact layer separating groove 14 is formed, can be prevented as much as possible from being connected to the amorphous p-layer 91p or the amorphous n-layer 91n.

It was found that there is a predetermined relationship between the power density ($J/cm^2$) of a nanosecond pulsed laser and the processing depth, and the power density of a nanosecond pulsed laser is adjusted based on this relationship, thereby determining the termination position 14L of the intermediate contact layer separating groove 14. Thus, it is possible to process the intermediate contact layer separating groove 14 to have a desired depth with high reproducibility.

In this embodiment, the solar cell shown in FIG. 1 has a tandem structure in which two power generation layers, namely, the first cell layer 91 and the second cell layer 92, are laminated; however, the present invention is not limited to the tandem structure, and it can be widely applied to a case where a silicon material is recrystallized when the intermediate contact layer separating groove is laser-processed. For example, the present invention can be used for a triple structure in which three power generation layers are laminated, and intermediate contact layers are formed between the respective power generation layers.

In this embodiment, the nanosecond pulsed laser is used as a laser for processing the intermediate contact layer separating groove 14; however, the present invention is not limited to this. For example, a picosecond pulsed laser having a pulse width of 10 to 750 ps may be used.

Reference Signs List

    1 glass substrate
    2 transparent electrode layer
    4 back electrode layer
    5 power generation cell
    10 solar cell (photoelectric conversion device)
    14 intermediate contact layer separating groove
    15 recrystallized region
    91 top layer (first photoelectric conversion layer)
    92 bottom layer (second photoelectric conversion layer)
    93 intermediate contact layer

**Claims**

1. A photoelectric conversion device fabrication method comprising:

    a first photoelectric conversion layer forming process of forming a first photoelectric conversion layer that mainly contains silicon;
    an intermediate contact layer forming process of forming, on the first photoelectric conversion layer, an intermediate contact layer that is electrically and optically connected to the first photoelectric conversion layer;
    an intermediate contact layer separating process of removing the intermediate contact layer through irradiation with a laser and forming an intermediate contact layer separating groove that reaches the first photoelectric conversion layer, to separate the intermediate contact layer; and
    a second photoelectric conversion layer forming process of forming a second photoelectric conversion layer that mainly contains silicon and that is electrically and optically connected to the intermediate contact layer, on the intermediate contact layer and in the intermediate contact layer separating groove, wherein:

        the first photoelectric conversion layer is composed of an i-layer, a p-layer, and an n-layer, the p-layer and the n-layer being formed so as to sandwich the i-layer; and
        in the intermediate contact layer separating process, the intermediate contact layer separating groove is formed so as to terminate in the i-layer of the first photoelectric conversion layer.

2. A photoelectric conversion device fabrication method according to claim 1, wherein the termination position of the intermediate contact layer separating groove is at substantially the center in a film thickness direction of the i-layer.

3.  A photoelectric conversion device fabrication method according to claim 1 or 2, wherein the termination position of the intermediate contact layer separating groove is determined by adjusting a power density indicating the output of the pulsed laser per unit area.

4.  A photoelectric conversion device comprising:

    a first photoelectric conversion layer that mainly contains silicon;
    an intermediate contact layer that is electrically and optically connected to the first photoelectric conversion layer; and
    a second photoelectric conversion layer that mainly contains silicon and that is electrically and optically connected to the intermediate contact layer, wherein:

    an intermediate contact layer separating groove that passes through the intermediate contact layer so as to separate the intermediate contact layer and that reaches the first photoelectric conversion layer is formed;
    the first photoelectric conversion layer is composed of an i-layer, a p-layer, and an n-layer, the p-layer and the n-layer being formed so as to sandwich the i-layer; and
    the intermediate contact layer separating groove is terminated in the i-layer of the first photoelectric conversion layer.

5.  A photoelectric conversion device according to claim 4, wherein the termination position of the intermediate contact layer separating groove is at substantially the center in a film thickness direction of the i-layer.

FIG. 1

# FIG. 2

# FIG. 3

# FIG. 4

BEAM ENERGY DENSITY $(J/cm^2)$

# FIG. 5

## INTERNATIONAL SEARCH REPORT

| | International application No. |
|---|---|
| | PCT/JP2009/067247 |

**A. CLASSIFICATION OF SUBJECT MATTER**
*H01L31/04*(2006.01)i

According to International Patent Classification (IPC) or to both national classification and IPC

**B. FIELDS SEARCHED**

Minimum documentation searched (classification system followed by classification symbols)
H01L31/04

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-313872 A (Mitsubishi Heavy Industries, Ltd.), 16 November 2006 (16.11.2006), paragraphs [0039], [0048]; fig. 1 (Family: none) | 1-5 |
| Y | JP 2001-274447 A (Kaneka Corp.), 05 October 2001 (05.10.2001), paragraphs [0025], [0031] (Family: none) | 1-5 |
| A | JP 2003-298089 A (Kaneka Corp.), 17 October 2003 (17.10.2003), Mode for carrying out the Invention; fig. 1 to 2 (Family: none) | 1-5 |

☒ Further documents are listed in the continuation of Box C. ☐ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30 November, 2009 (30.11.09) | 15 December, 2009 (15.12.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/067247 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2003-273383 A  (Sharp Corp.),<br>26 September 2003 (26.09.2003),<br>entire text; all drawings<br>& US 2003/0172967 A1 | 1-5 |
| A | JP 2005-38907 A  (Kyocera Corp.),<br>10 February 2005 (10.02.2005),<br>entire text; all drawings<br>(Family: none) | 1-5 |

Form PCT/ISA/210 (continuation of second sheet) (April 2007)

**EP 2 346 087 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002261308 A
- JP 2006313872 A